# EUROPEAN PATENT APPLICATION

(11) **EP 3 943 636 A1**
(43) Date of publication of application: **26.01.2022**
(21) Application number: 21186268.5
(22) Date of filing: 16.07.2021
(51) Int. Cl.: C23C 4/02, C23C 4/10, C23C 4/11, C23C 4/134, C23C 4/18, C23C 14/00, C23C 16/00, C23C 28/04

(54) **CMAS-RESISTANT THEMAL COATING FOR PART OF GAS TURBINE ENGINE**

(30) Priority: 22.07.2020 US 202016936166
(71) Applicant: Honeywell International Inc., Charlotte, NC 28202 (US)
(72) Inventor: VAN SLUYTMAN, Jason, Charlotte, 28202 (US); TOLPYGO, Vladimir, Charlotte, 28202 (US)
(74) Representative: LKGlobal UK Ltd.

(57) **Abstract**

A method of manufacturing a part with a CMAS-resistant thermal coating includes providing a part body having a surface and forming a thermal barrier coating (TBC) layer on the surface. The method also includes providing a precursor of a CMAS-reactive material and depositing the CMAS-reactive material on the TBC layer using the precursor.

## Description

### TECHNICAL FIELD

The present disclosure generally relates to a thermal barrier coating and, more particularly, relates to a CMAS-resistant thermal coating for a part, such as a part of a gas turbine engine.

### BACKGROUND

Many components, such as gas turbine engines, include parts with a thermal barrier coating (TBC). The TBC can have low thermal conductivity and may be layered on a part for thermally protecting the part in a high-temperature environment. For example, a component of a gas turbine section may include blades, vanes, or other parts made of a material (e.g., a superalloy) that is protected from high-temperature gases by the TBC.

However, many TBCs have limited durability and robustness. The TBC may degrade prematurely, for example, due to exposure to calcium magnesium aluminosilicate (i.e., CMAS). A gas turbine engine may ingest sand, ash, and/or dust, and these fine particle may volatilize as hydroxides or become molten and react with the TBC. In other words, there may be liquid-phase and/or vapor-phase infiltration of CMAS constituents into the TBC over time. This infiltration of CMAS may result in stiffening and loss of strain compliance of the TBC leading to spallation upon cooling. Furthermore, there may be weakening of the bond between the TBC and the underlying thermally grown oxide (TGO), the latter of which grows atop a metallic bond coat.

Additionally, existing manufacturing methods for forming parts with durable and robust TBCs are limited. These methods can be resource-intensive, expensive, time consuming, or otherwise disadvantageous.

Accordingly, there is a longstanding and on-going need for a more durable and robust TBC. Specifically, there is a need for an improved CMAS-resistant TBC, which significantly reduces CMAS infiltration into the CMAS. Additionally, there is a need for improved manufacturing methods, which are used to provide these types of CMAS-resistant TBCs, which utilize improved materials, implements, etc., and/or which are increasingly cost-effective.

### BRIEF SUMMARY

This summary is provided to describe select concepts in a simplified form that are further described in the Detailed Description. This summary is not intended to identify key or essential features of the claimed subject matter, nor is it intended to be used as an aid in determining the scope of the claimed subject matter.

A method of manufacturing a part with a CMAS-resistant thermal coating includes providing a part body having a surface and forming a thermal barrier coating (TBC) layer on the surface. The method also includes providing a precursor of a CMAS-reactive material and depositing the CMAS-reactive material on the TBC layer using the precursor.

Furthermore, a part with a thermal coating is disclosed. The part includes a part body and a thermal barrier coating (TBC) layer layered on the part body. Also, the thermal coating includes a plurality of precipitations of a CMAS-reactive material on the TBC.

Moreover, a method of manufacturing a part of a gas turbine engine with a thermal coating is disclosed. The method includes providing a gas turbine engine part body, wherein the gas turbine engine part has a surface. The method further includes forming a thermal barrier coating (TBC) layer on the surface. The TBC layer includes a rare-earth-doped zirconia ceramic, and the TBC layer includes a plurality of voids therein. The TBC layer also defines an outer boundary. Furthermore, the method includes providing a soluble, metal-containing precursor of a CMAS-reactive material. Also, the method includes creating a flow at least partly from the precursor provided. The method additionally includes directing the flow to the TBC layer to condense a plurality of precipitations of the CMAS-reactive material on the TBC layer, at least some of the plurality of precipitations being condensed on the outer boundary, and at least some others of the plurality of precipitations being condensed within at least some of the plurality of voids.

Other desirable features and characteristics of the apparatus and method will become apparent from the subsequent detailed description and the appended claims, taken in conjunction with the accompanying drawings and the preceding background.

### BRIEF DESCRIPTION OF THE DRAWINGS

The present disclosure will hereinafter be described in conjunction with the following drawing figures, wherein like numerals denote like elements, and wherein:
FIG. 1 is a schematic view of a gas turbine engine according to example embodiments of the present disclosure;
FIG. 2 is a schematic isometric sectional view of a part of the gas turbine engine of FIG. 1 with a CMAS-resistant thermal coating according to example embodiments of the present disclosure;
FIG. 3 is a cross sectional view of the thermal coating according to additional embodiments of the present disclosure; and
FIG. 4 is a schematic view representing methods of manufacturing, including providing the thermal coating, according to example embodiments of the present disclosure.

### DETAILED DESCRIPTION

The following detailed description is merely exemplary in nature and is not intended to limit the present disclosure or the application and uses of the present disclosure. As used herein, the word "exemplary" means "serving as an example, instance, or illustration." Thus, any embodiment described herein as "exemplary" is not necessarily to be construed as preferred or advantageous over other embodiments. All of the embodiments described herein are exemplary embodiments provided to enable persons skilled in the art to make or use the present disclosure and not to limit the scope of the present disclosure which is defined by the claims. Furthermore, there is no intention to be bound by any expressed or implied theory presented in the preceding technical field, background, brief summary, or the following detailed description.

Broadly, embodiments of the present disclosure include improved thermally coated parts and improved methods for manufacturing such thermally coated parts. The part may include a thermal barrier coating (TBC) layer and an amount of CMAS-reactive material included on the TBC layer. In some embodiments, the TBC layer includes a zirconia-based ceramic, which is doped with yttria (Y) and/or another oxide of a rare-earth element (e.g., Yb, Sc, Gd, Er, La, etc.). Furthermore, in some embodiments, the CMAS-reactive material is a material containing aluminum and/or a rare-earth element. In an example embodiment, the TBC layer includes a yttria-stabilized zirconia (YSZ) ceramic material, and the CMAS-reactive material includes alumina.

Manufacturing methods of the present disclosure, in some embodiments, may include useful and efficient options for delivering and depositing the CMAS-resistant TBC on various parts. In some embodiments, materials of the CMAS-resistant TBC are deposited on the part in predetermined, controlled conditions, wherein a flow of materials is created for deposition of the CMAS-reactive material. An example manufacturing method of the present disclosure may include providing a part with a TBC layer and subsequently depositing the CMAS-reactive material thereon. More specifically, in some embodiments, , a precursor of the CMAS-reactive material (e.g., a metal-containing material such as a metal nitrate hydrate) is provided for depositing the CMAS-reactive material onto the TBC layer. The method may include creating the flow of, at least, the precursor of the CMAS-reactive material. The flow (e.g., a vapor, thermal spray, etc.) may be directed toward the TBC layer to condense the CMAS-reactive material on the previously-formed TBC. The CMAS-reactive material may collect, precipitate, agglomerate, layer, or otherwise accumulate on the TBC layer. For example, the CMAS-reactive material may collect on deposits of the TBC (e.g., on columns or other accumulations of material of the TBC). The CMAS-reactive material may also collect, precipitate, agglomerate, layer, or otherwise accumulate within voids defined between the deposits of the TBC (e.g., between columns of the TBC layer).

The CMAS-reactive material included on this treated TBC layer may react with CMAS materials during subsequent exposure. More specifically, the CMAS-reactive material may react with the CMAS, creating solid precipitates that limit further infiltration of CMAS material into the TBC.

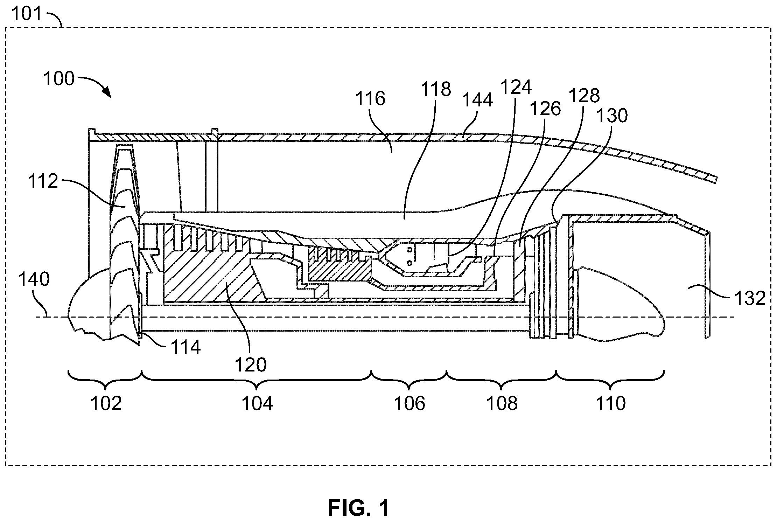

With reference to FIG. 1, a partial, cross-sectional view of an exemplary gas turbine engine 100 is shown with the remaining portion of the gas turbine engine 100 being substantially axisymmetric about a longitudinal axis 140, which also defines an axis of rotation for the gas turbine engine 100. In the depicted embodiment, the gas turbine engine 100 is an annular multi-spool turbofan gas turbine j et engine within an aircraft (represented schematically at 101), although features of the present disclosure may be included in other configurations, arrangements, and/or uses. For example, in other embodiments, the gas turbine engine 100 may assume the form of a non-propulsive engine, such as an Auxiliary Power Unit (APU) deployed onboard the aircraft 101, or an industrial power generator.

In this example, with continued reference to FIG. 1, the gas turbine engine 100 includes a fan section 102, a compressor section 104, a combustor section 106, a turbine section 108, and an exhaust section 110. In one example, the fan section 102 includes a fan 112 mounted on a rotor 114 that draws air into the gas turbine engine 100 and compresses it. A fraction of the compressed air exhausted from the fan 112 is directed through the outer bypass duct 116 and the remaining fraction of air exhausted from the fan 112 is directed into the compressor section 104. The outer bypass duct 116 is generally defined by an outer casing 144 that is spaced apart from and surrounds an inner bypass duct 118.

In the embodiment of FIG. 1, the compressor section 104 includes one or more compressors 120. The number of compressors 120 in the compressor section 104 and the configuration thereof may vary. The one or more compressors 120 sequentially raise the pressure of the air and direct a majority of the high-pressure fluid or air into the combustor section 106. In the combustor section 106, which includes a combustion chamber 124, the high-pressure air is mixed with fuel and is combusted. The high-temperature combustion air or combustive gas flow is directed into the turbine section 108. In this example, the turbine section 108 includes three turbines disposed in axial flow series, namely, a high-pressure turbine 126, an intermediate pressure turbine 128, and a low-pressure turbine 130. However, it will be appreciated that the number of turbines, and/or the configurations thereof, may vary. In this embodiment, the high-temperature combusted air from the combustor section 106 expands through and rotates each turbine 126, 128, and 130. The combustive gas flow then exits the turbine section 108 for mixture with the cooler bypass airflow from the outer bypass duct 116 and is ultimately discharged from the gas turbine engine 100 through the exhaust section 132. As the turbines 126, 128, 130 rotate, each drives equipment in the gas turbine engine 100 via concentrically disposed shafts or spools.

In some situations, CMAS may be ingested at the air inlet (through the fan section 102) and further delivered into the combustor and turbine sections 106, 108. The CMAS may turn molten and/or vaporized. Embodiments of TBCs discussed below may be CMAS-resistant to avoid deleterious effects from the CMAS.

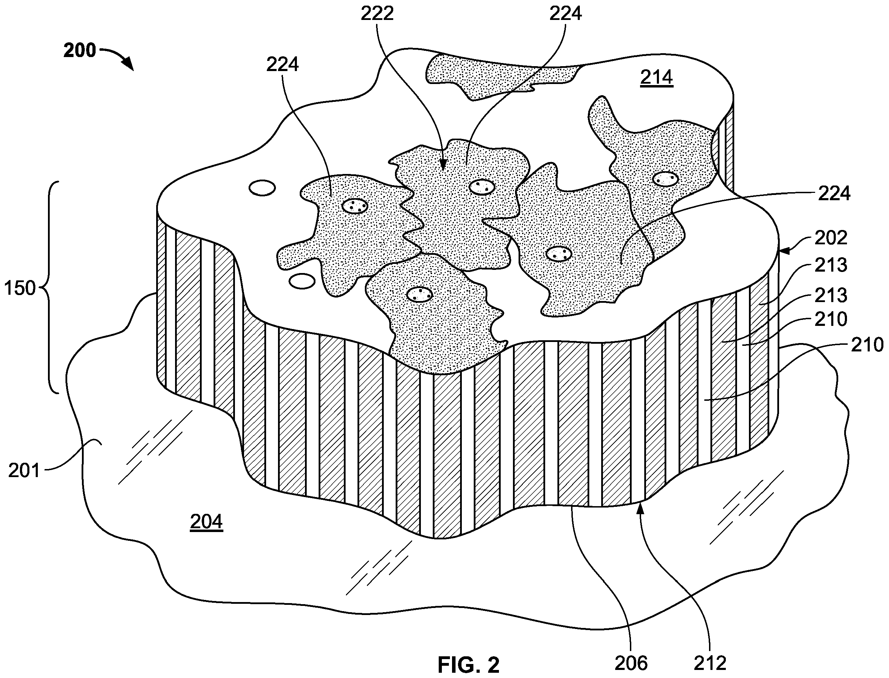

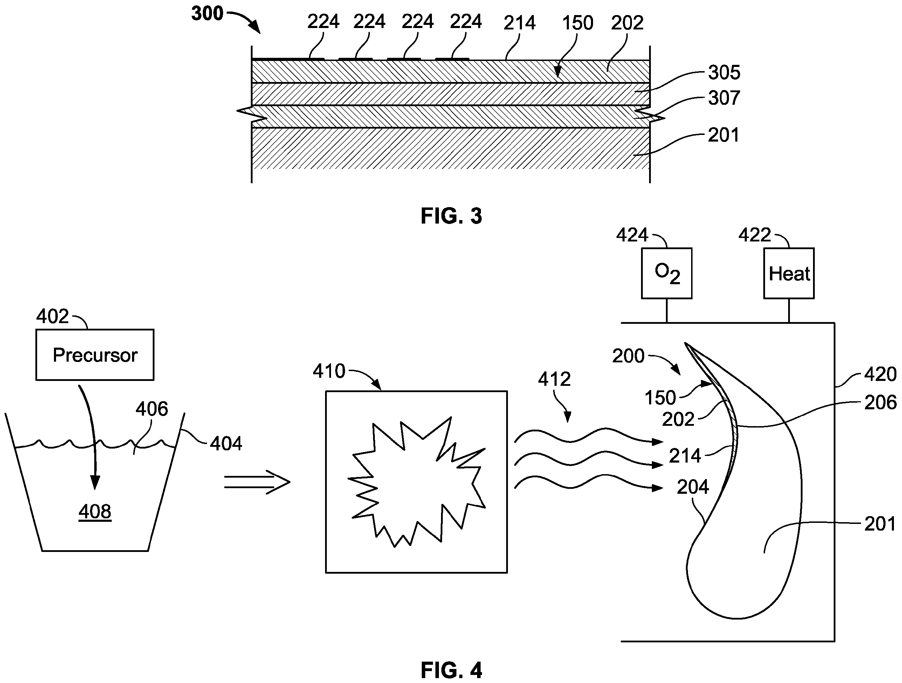

Referring now to FIG. 2, a CMAS-resistant thermal coating 150 of a part 200 is shown schematically. As shown in FIG. 3, the part 200 may be a blade, a vane, or other airfoil-shaped component of the gas turbine engine 100; however, the part 200 may have a variety of shapes without departing from the scope of the present disclosure. In some embodiments, the part 200 may be included in an area of the engine 100 subjected to high-temperature environments. Thus, the part 200 may be a component of the combustor section 106, a component of the turbine section 108, etc. It will be appreciated that the part 200 may be another component of the gas turbine engine 100, or the part 200 may be included in something other than a gas turbine engine without departing from the scope of the present disclosure.

The part 200 may include a body 201 that defines the majority of the part 200. The body 201 may be made of any suitable material. For example, in some embodiments, the body 201 may be made of or include a metallic superalloy (e.g., a nickel-based superalloy). The body 201 may also include an outer surface 204. The outer surface 204 may be contoured or substantially flat. For example, the outer surface 204 may at least partly define the airfoil shape mentioned above.

The part 200 may also include a bond coat 206. The bond coat 206 may be a metallic coating on the outer surface 204. In some embodiments, the bond coat 206 may have a thermally-grown oxide material, such as aluminum oxide. Thus, the bond coat 206 may be a metallic bond coat that provides oxidation protection of the part 200.

The CMAS-resistant thermal coating 150 may include at least one layer of a thermal barrier coating (TBC layer) 202. The TBC layer 202 may include an inner boundary 212 that faces the bond coat 206 and the surface 204. The TBC layer 202 may also include an outer boundary 214 that faces away from the bond coat 206 and the surface 204. The TBC layer 202 may have a thickness (measured between the inner and outer boundaries 212, 214) that is between approximately 0.1 to 2 mm in some embodiments.

The TBC layer 202 may be layered on the bond coat 206 with the bond coat 206 disposed in a thickness direction between the inner boundary 212 of the TBC layer 202 and the outer surface 204 of the body 201. As such, the bond coat 206 bonds the TBC layer 202 to the outer surface 204 of the body 201.

In general, the TBC layer 202 may be a ceramic material (i.e., formed primarily from a ceramic), and the TBC layer 202 may have low thermal conductivity for thermally protecting the underlying body 201. The microstructure of the TBC layer 202 may include a plurality of voids 210 (i.e., pores, gaps, etc.), as represented schematically in FIG. 2. More specifically, the TBC layer 202 may define a plurality of deposits, such as columns 213 that extend longitudinally away from the body 201 of the part 200, and the voids 210 may be defined between the respective columns 213. In other embodiments, the voids 210 may be pores, cavities within a more continuous application of the TBC layer 202. The voids 210 may increase the strain compliance of the TBC layer 202. For example, in some embodiments, the body 201 may have a significantly higher rate of thermal expansion than the TBC layer 202. However, the voids 210 may provide a degree of strain compliance to the TBC layer 202 for accommodating the thermal mismatch.

Although the columns 213 and voids 210 are shown in FIG. 2 as having a uniform size, a uniform alternating arrangement, etc., those having ordinary skill in the art will recognize that those features are illustrated schematically for simplicity. In actuality, the columns 213 and voids 210 do not generally exhibit uniform size, arrangement, etc. Furthermore, the columns 213 and voids 210 may not extend continuously from the bond coat 206 to the outer boundary 214; instead, some of the columns 213 and/or voids 210 may extend from the bond coat 206 and may be covered over in the thickness direction by other columns 213 and/or voids 210.

The TBC layer 202 may be made from a variety of materials without departing from the scope of the present disclosure. In general, the TBC layer 202 may exhibit relatively low thermal conductivity. The TBC layer 202 may exhibit lower thermal conductivity than the material of the part body 201. As such, the TBC layer 202 may thermally protect the underlying body 201. In some embodiments, the TBC layer 202 may include a zirconia-based ceramic, which is doped with, but not limited to, yttria (Y₂O₃) and/or other rare-earth (RE) oxides (REs: Yb, Sc, Gd, Er, La, etc.). The rare-earth-doped zirconia ceramic may be doped with 3-50 weight percent (wt%) of yttria, or a similar weight range for each of the aforementioned rare-earth oxides. Combinations of the rare-earth oxides may also be included in some embodiments.

Additionally, the CMAS-resistant thermal coating 150 of the part 200 may include an amount of a CMAS-reactive material 222 on the TBC layer 202. The CMAS-reactive material 222 may be included proximate the outer boundary 214 of the TBC layer 202. The CMAS-reactive material 222 may be included at least partly within at least some of the voids 210. The CMAS-reactive material 222 may be included in a variety of amounts, provided in a variety of thicknesses, and provided in a number of different arrangements without departing from the scope of the present disclosure. For example, the CMAS-reactive material 222 may be provided in a substantially continuous layer over the outer boundary 214. The CMAS-reactive material 222 may be provided as agglomerations (continuous or discontinuous) over the outer boundary 214. The CMAS-reactive material 222 may be provided as precipitations over the outer boundary 214 and at least partly within the voids 210. For example, CMAS-reactive material 222 may span from the outer boundary 214 and over the interior surfaces of the voids 210 that are proximate the outer boundary 214.

In embodiments illustrated in FIG. 2, the CMAS-reactive material 222 may be provided as a plurality of precipitations 224 on the outer boundary 214 and within voids 210 of the TBC layer 202. The precipitations 224 may be included in one or more discrete areas having an area that falls within a predetermined size range (e.g., anywhere between 0.001 and 10 microns) of accumulated CMAS-reactive material 222 on the outer boundary 214 (the outer surface). The voids 210 that are included within these areas may also include the material 222 therein. Thus, the precipitations 224 may be accumulations of the CMAS-reactive material in areas spanning part of the outer boundary 214 (the outer surface) and at least some of the interior of the voids 210. In some embodiments, each precipitation 224 may include particles of CMAS-reactive material with sizes that fall within a predetermined range (e.g., anywhere between approximately 0.001-10um).

Generally, the CMAS-reactive material 222 may be chemically reactive with CMAS materials and substantially nonreactive (chemically inert) with the TBC layer 202. In some embodiments, the CMAS-reactive material 222 may be an aluminum-containing material, such as aluminum oxide (i.e., alumina, Al₂O₃). Additionally, in some embodiments, the CMAS-reactive material 222 may include an oxide of at least rare earth element. The CMAS-reactive material 222 may provide effective CMAS protection, and yet the TBC layer 202 may still exhibit sufficiently low thermal conductivity, effective strain compliance, and high mechanical integrity.

In additional embodiments represented in FIG. 3, the CMAS-resistant thermal coating 150 discussed above may be one of a plurality of thermal coating applications 300 on the part body 201. Each may be formed in independent coating manufacturing processes. For example, the thermal coating 150 may be an outermost one of the thermal coating applications 300. As such, the precipitations 224 of CMAS-reactive material 222 may be disposed on the outermost outer boundary 214 and may define the thermal coating application that is furthest away from the part body 201. The plurality of thermal coating applications 300 may include at least one interior application that is disposed (in the thickness direction) between the thermal coating 150 and the body 201. Specifically, in the embodiments represented in FIG. 3, there may be a first thermal coating application 305 and a second thermal coating application 307 included; however, there may be any number of applications without departing from the scope of the present disclosure. The first and second thermal coating applications 305, 307 may be formed from rare-earth-doped zirconia ceramic material. Moreover, in some embodiments, there may be alternating layers of conventional TBCs and thermal coatings 150 of the type discussed above.

Referring now to FIG. 4, methods of manufacturing will be discussed according to example embodiments of the present disclosure. Generally, the TBC layer 202 may be formed on the part body 201, and the CMAS-reactive material 222 may be subsequently deposited and dispersed on the outer boundary 214. As will be discussed, the CMAS-reactive material 222 may be provided by directing a flow (e.g., a vapor, gas, plume, cloud, etc.) of material to the TBC layer 202. The flow may be created from a precursor 402 of the CMAS-reactive material 222. During deposition of the CMAS-reactive material 222, the flow may be naturally and passively toward the part body 201, or may be actively applied (e.g., sprayed or otherwise propelled) toward the part body 201 using one or more implements.

As shown, the method 400 may include providing the precursor 402 of the CMAS-reactive material. 222. In some embodiments, the precursor 402 may be a soluble, metal-containing precursor 402, such as an aluminum-containing precursor 402. The precursor 402 may be combined and dissolved with a liquid solvent (e.g., a water- or alcohol-based solvent) in a container 404. This solution may be heated to cause it to evaporate and volatize. The resulting flow 412 may be directed toward the previously-formed TBC layer 202 to condense the CMAS-reactive material on the outer boundary 214. The liquid (e.g., water 406) may evaporate again, leaving the precipitations 224 on the outer boundary 214 and within the voids 210.

In some embodiments, the precursor 402 may be aluminum nitrate hexa-hydrate, Al(NO3)3-9H2O, which is water soluble. This precursor 402 is advantageous because aluminum nitrate hexa-hydrate is widely available and relatively inexpensive. Also, this precursor 402 is water soluble, and water vapor may be the medium for transporting/transferring and applying the CMAS-reactive material 222 to the part body 201. This provides added manufacturing efficiencies. Other precursors 402 may be used without departing from the scope of the present disclosure. One or more metal-nitrate hydrates may be used as the precursor 402. Other aluminum halides, such as, but not limited to, aluminum chloride, aluminum bromide, aluminum fluoride, and aluminum iodide may be used in additional embodiments. The precursor 402 and water 406 may be mixed in the container 404 to produce a liquid solution 408 containing the precursor 402. The solution 408 may be mixed at a predetermined ratio (e.g., a precursor-to-solvent ratio ranging from 1:10 to 1:100).

Next, as shown in FIG. 4, the solution 408 may be provided to a deposition device 410. The deposition device 410 generates a flow 412 from the solution 408. In some embodiments, the deposition device 410 may include a heat source, such as a combustion source, flame, resistive heater, or other heating device that evaporates the solution 408 and produces the flow 412. In some embodiments, the deposition device 410 may also include or may be operably coupled to a thermal spray device or other flow control device, sprayer, flow chamber, etc.

In some embodiments, the flow 412 is a plume, spray, vapor, atomized flow, volatized flow containing aluminum. For example, where the precursor 402 is aluminum nitrate hexa-hydrate, Al(NO3)3-9H2O, the deposition device 410 may create the aluminum-containing flow 412 from the solution 408. There may be a chemical reaction of the precursor 402 as it is converted into the flow 412 (e.g., the precursor 402 may be converted into aluminum-hydroxide). The flow 412 may be directed toward the part body 201 and the TBC layer 202 so as to deposit and condense the CMAS-reactive material 222 on the TBC layer 202.

More specifically, the part body 201 may be provided inside a chamber 420. The chamber 420 may be airtight so as to selectively contain a vacuum. The chamber 420 may be configured for one or more environmental controls. For example, the chamber 420 may be operably coupled to a heating unit 422 for controlling the temperature inside the chamber 420. In some embodiments, the chamber 420 may be heated to temperatures above 2000°F (e.g., to 2050°F). The chamber 420 may also be operably coupled to an oxygen unit 424 for controlling the oxygen level therein.

The part body 201 may be provided with the bond coat 206 and the TBC layer 202 thereon. The bond coat 206 and TBC layer 202 may be formed inside the chamber 420, before the CMAS-reactive material 222 is added thereto. In multi-layer coatings of the type represented in FIG. 3, the part body 201 may be provided with the first and second coating applications 305, 307 and the TBC layer 202.

To add the CMAS-reactive material 222, the flow 412 is directed to the previously-formed TBC layer 202. Within the heated environment of the chamber 420, the aluminum-containing flow 412 may condense onto the outer boundary 214 of the TBC layer 202. The aluminum-containing material within the condensation may chemically react within the oxygen-enriched environment to create aluminum oxide (alumina) as precipitations 224 on the outer boundary 214 and within the voids 210.

Before adding the thermal coating 150, the part body 201 may be prepared such that the thermal coating 150 is added only to predetermined areas and not others. For example, areas of the part body 201 may be masked and the flow 412 may be applied to unmasked areas to add the CMAS-reactive material 222. Parts of the TBC layer 202 may be similarly masked.

Those having ordinary skill in the art will appreciate that a number of materials may be utilized for providing the CMAS-reactive material 222 to the thermal coating 150. For example, other than aluminum nitrate, those having skilled in the art will appreciate that other types of chemicals could be used, such as other metal-containing precursors of the CMAS-reactive material 222 (e.g., other metal nitrates). A number of RE nitrates may be utilized, including, but not limited to yttrium-, ytterbium, gadolinium-, lanthanum-, erbium-, samarium-, nitrate or some combination thereof. These materials may condense and convert into the respective oxide as discussed above and, thus, the CMAS-reactive material 222 may include, but are not limited to, aluminum oxide, lanthanum oxide (lanthana), or other RE-oxides, or a combination thereof.

Moreover, the methods 400 discussed above may include electron-beam physical vapor deposition (EBPVD), air plasma spray (APS), suspension plasma spray (SPS), so-called SOL-GEL processes, magnetron/ion sputtering, or another suitable process.

In the case of EBPVD, the flow 412 may be a vapor formed via an electron beam physical vapor deposition (EBPVD) method in some embodiments. The solution 408 may be heated to create the vapor. More specifically, the solution 408 may be operably coupled to a filament and bombarded with an electron beam given off by the filament under a vacuum. The electron beam causes molecules of the liquid solution 408 to vaporize. The flow 412 may be directed toward the body 201 within the chamber 420. The vapor may precipitate into solid form (condense) on the TBC layer 202.

In additional embodiments, the TBC layer 202 and the CMAS-reactive material 222 may be formed on the body 201 via a thermal spray process. More specifically, an air plasma spray process may be used. The TBC layer 202 may be applied in a conventional manner. Then, the CMAS-reactive material 222 may be applied using a spray tool that is coupled to the deposition device 410. The precursor 402 may be provided as a powder that is heated into a molten or semi-molten state and introduced into a plasma jet as a sprayed flow 412. The flow 412 may be sprayed from the tool toward the body 201.

In further embodiments that include thermal spraying, the CMAS-reactive material 222 may be provided via a suspension plasma spray process. Moreover, the CMAS-reactive material 222 may be provided using a plasma-enhanced chemical vapor deposition process. Otherwise, the CMAS-reactive material 222 may be provided using a so-called Sol-gel process or via a magnetron/ion sputtering process.

It will be appreciated that multiple bodies 201 may be provided for substantially simultaneously forming thermal coatings 150 on a plurality of parts in one continuous process. In embodiments of FIG. 4, a plurality of bodies 201 may be provided at one time within the chamber 420, and the flow 412 may be directed toward these bodies 201 for forming the thermal coatings 150 thereon.

Once the thermal coating 150 is formed, the part body 201 may undergo further processing, such as heat treatment, installation into the gas turbine engine 100, etc. The thermal coating 150 may provide thermal protection at elevated operating temperatures. Also, if CMAS is ingested into the gas turbine engine 100, the CMAS may chemically react with the CMAS-reactive material 222 of the thermal coating 150. For example, as the CMAS reacts with alumina, crystalline precipitates may be formed in the voids 210, and these precipitates may effectively block the TBC layer 202 against further infiltration of CMAS. This reaction may increase the melting temperature of the CMAS material and promote formation of the precipitates. The precipitates may be solid crystalline phases made out of one or more materials, such as anorthite, apatite, spinel, etc. The precipitates may block the voids 210 or restrict further infiltration of liquid or vapor CMAS material into the TBC layer 202. Thus, the thermal coating 150 can provide effective thermal protection and robust protection against CMAS, while also maintaining high strain resistance.

In other embodiments, the body 201 may be treated before installation on the gas turbine engine 100. For example, it may be desirable to form the precipitates in the thermal coating 150 under predetermined, controlled conditions before the engine 100 is put into service. In some embodiments, after the thermal coating 150 is formed, the thermal coating 150 may be selectively exposed to high temperature and to CMAS, thus forming the protective precipitates described above. Subsequently the body 201 may be fully installed into the engine 100 and/or otherwise put into full operational service with significant protection against further intrusion of CMAS.

These manufacturing methods 400 provide a number of advantages. The precursor 402 can be a widely-available and inexpensive. The part body 201 is also protected from corrosion or other damage during the method 400 of manufacturing as well. This may also be a standalone process, which can be incorporated within existing manufacturing processes and facilities easily.

In this document, relational terms such as first and second, and the like may be used solely to distinguish one entity or action from another entity or action without necessarily requiring or implying any actual such relationship or order between such entities or actions. Numerical ordinals such as "first," "second," "third," etc. simply denote different singles of a plurality and do not imply any order or sequence unless specifically defined by the claim language. The sequence of the text in any of the claims does not imply that process steps must be performed in a temporal or logical order according to such sequence unless it is specifically defined by the language of the claim. The process steps may be interchanged in any order without departing from the scope of the invention as long as such an interchange does not contradict the claim language and is not logically nonsensical.

Furthermore, depending on the context, words such as "connect" or "coupled to" used in describing a relationship between different elements do not imply that a direct physical connection must be made between these elements. For example, two elements may be connected to each other physically, electronically, logically, or in any other manner, through one or more additional elements.

While at least one exemplary embodiment has been presented in the foregoing detailed description of the invention, it should be appreciated that a vast number of variations exist. It should also be appreciated that the exemplary embodiment or exemplary embodiments are only examples, and are not intended to limit the scope, applicability, or configuration of the invention in any way. Rather, the foregoing detailed description will provide those skilled in the art with a convenient road map for implementing an exemplary embodiment of the invention. It being understood that various changes may be made in the function and arrangement of elements described in an exemplary embodiment without departing from the scope of the invention as set forth in the appended claims.

## Claims

1. A method of manufacturing a part with a CMAS-resistant thermal coating comprising:
providing a part body having a surface;
forming a thermal barrier coating (TBC) layer on the surface;
providing a precursor of a CMAS-reactive material;
depositing the CMAS-reactive material on the TBC layer using the precursor.

2. The method of claim 1, wherein the precursor is a metal-containing material and the CMAS-reactive material is chosen from a group consisting of alumina and an oxide of at least one rare-earth element.

3. The method of claim 1, wherein the precursor is a metal-nitrate hydrate and is, optionally, aluminum nitrate hexahydrate (Al(NO₃)₃-9H₂0).

4. The method of claim 1, wherein providing the precursor includes dissolving the precursor in a liquid solvent and, optionally, providing the precursor in the liquid solvent at a ratio between approximately 1:10 to 1:100.

5. The method of claim 1, wherein forming the TBC layer includes forming a plurality of voids within the TBC layer; and
further comprising condensing the CMAS-reactive material into at least some of the plurality of voids.

6. The method of claim 1, further comprising condensing the CMAS-reactive material into a plurality of precipitations having a respective size that is, at most, ten micrometers (10um).

7. The method of claim 1, wherein the TBC layer includes a zirconia-based ceramic that is doped with at least one oxide of a rare-earth material.

8. The method of claim 1, further comprising at least one of:
providing the precursor to a thermal spray device and thermal spraying to deposit the CMAS-reactive material on the TBC layer;
creating a vapor from the precursor that flows to the TBC to be deposited thereon;
providing the part body with the TBC layer in an oxygen-enriched environment and depositing the CMAS-reactive material within the oxygen-enriched environment to condense the CMAS-reactive material as an oxide thereon; and
providing the part body with the TBC layer in a heated environment and depositing the CMAS-reactive material within the heated environment to condense the CMAS-reactive material thereon.

9. The method of claim 1, wherein the part is a gas turbine engine part;
wherein the TBC layer includes a rare-earth-doped zirconia ceramic, the TBC layer including a plurality of voids therein, the TBC layer defining an outer boundary;
wherein providing the precursor includes providing a soluble, metal-containing precursor of the CMAS-reactive material; and
further comprising creating a flow at least partly from the precursor provided and directing the flow to the TBC layer to condense a plurality of precipitations of the CMAS-reactive material on the TBC layer, at least some of the plurality of precipitations being condensed on the outer boundary, and at least some others of the plurality of precipitations being condensed within at least some of the plurality of voids.

10. A part manufactured according to the method of claim 1, comprising:
the part body;
the thermal barrier coating (TBC) layer layered on the part body; and
a plurality of precipitations of the CMAS-reactive material on the TBC.

11. The part of claim 10, wherein the TBC layer includes a plurality of voids therein; and
wherein at least some of the plurality of precipitations of the CMAS-reactive material are condensed within at least some of the plurality of voids.

12. The part of claim 11, wherein the plurality of precipitations have a respective size that is, at most, ten micrometers (10um).

13. The part of claim 10, wherein the CMAS-reactive material is chosen from a group consisting of alumina and an oxide of at least one rare-earth element.

14. The part of claim 10, wherein the TBC layer includes a zirconia-based ceramic that is doped with at least one oxide of a rare-earth material.

15. A gas turbine engine part manufactured according to the method of claim 1.
